## Europäisches Patentamt

## European Patent Office

## Office européen des brevets

(11) Veröffentlichungsnummer: **0 012 802**
**B1**

(12) **EUROPÄISCHE PATENTSCHRIFT**

(45) Veröffentlichungstag der Patentschrift: **09.03.83**

(51) Int. Cl.³: **G 11 C 7/00, G 11 C 11/24**

(21) Anmeldenummer: **79103925.8**

(22) Anmeldetag: **12.10.79**

(54) Dynamischer Halbleiterspeicher.

(30) Priorität: **20.12.78 DE 2855118**

(43) Veröffentlichungstag der Anmeldung:
**09.07.80 Patentblatt 80/14**

(45) Bekanntmachung des Hinweises auf die Patenterteilung:
**09.03.83 Patentblatt 83/10**

(84) Benannte Vertragsstaaten:
**DE FR GB NL SE**

(56) Entgegenhaltungen:
DE - A - 2 723 188
DE - A - 2 724 646
DE - A - 2 812 657
FR - A - 2 276 659
US - A - 3 678 473
US - A - 3 795 898
US - A - 4 054 865
US - A - 4 112 512
US - A - 4 122 546

(73) Patentinhaber: **International Business Machines Corporation**
**Armonk, N.Y. 10504 (US)**

(72) Erfinder: **Gschwendtner, Jörg**
**Seitenstrasse 38**
**D-7300 Esslingen (DE)**
Erfinder: **Haug, Werner**
**Pontoiser Strasse 43**
**D-7030 Böblingen (DE)**
Erfinder: **Clemen, Rainer**
**Maurener Weg 133**
**D-7030 Böblingen (DE)**

(74) Vertreter: **Rudolph, Wolfgang**
**Schönaicher Strasse 220**
**D-7030 Böblingen (DE)**

Courier Press, Leamington Spa, England.

(56) Entgegenhaltungen:

IBM TECHNICAL DISCLOSURE BULLETIN, Band 19, Nr. 7, Dezember 1976, Armonk, US, L. M. ARZUBI: "Twin cell, high performance write circuit", Seiten 2482—2483

IEEE JOURNAL OF SOLID-STATE CIRCUITS, Band SC-11, Nr. 5, Oktober 1976, New York, US, J. M. SCHLAGETER et al.: "Two 4K static 5-v RAM's", Seiten 602—609

IBM TECHNICAL DISCLOSURE BULLETIN, Band 17, Nr. 5, Oktober 1974, Armonk, US, J. M. LEE: "Cross-coupled latch for memory sensing", Seiten 1361—1362

IBM TECHNICAL DISCLOSURE BULLETIN, Band 17, Nr. 6, November 1974, Armonk, US, K. L. ANDERSON et al.: "Memory cell sensing scheme", Seiten 1567—1568

IBM TECHNICAL DISCLOSURE BULLETIN, Band 18, Nr. 3, August 1975, Armonk, US, H. BARSUHN et al.: "Semiconductor storage circuit utilizing two device memory cells", Seiten 786—787

## Dynamischer Halbleiterspeicher

Die Erfindung betrifft einen integrierten Halbleiterspeicher nach dem Oberbegriff des Patentanspruchs 1.

Ein derartiger Halbleiterspeicher ist aus der DE—B 2 712 735 und aus IBM Technical Disclosure Bulletin, Vol. 19, Nr. 7, Dez. 1976, Seiten 2482 und 2483 bekannt.

Mit der immer weiter zunehmenden Pakkungsdichte solcher Speicher ergeben sich allerdings insofern große Probleme, als das Signal beim Auslesen bzw. Abfühlen des Inhalts einer Speicherzelle fast nicht mehr zuverlässig wahrnehmbar klein wird. Dies erfordert zum einen äußerst komplizierte Abfühlschaltkreise und zum andern ein sehr genaues Einhalten sowohl der Zeitdauer als auch der Pegel einer ganzen Reihe von aufeinanderfolgenden Steuersignalen. Die Signalfolge für eine Leseoperation ist dabei noch verschieden von der für eine Schreiboperation, so daß viele Hilfsschaltkreise nötig sind, um einen derartigen Speicher überhaupt noch betreiben zu können. Außerdem sinkt die Arbeitsgeschwindigkeit mit abnehmender Größe des abgefühlten Signals.

Um schnellere Schreib- und Lesezyklen zu erreichen, wurden integrierte dynamische Halbleiterspeicher mit Zwei-Feldeffekttransistor-Speicherzellen ausgerüstet. Ein derartiger Speicher mit zwei über je einen Feldeffekttransistor zugänglichen Speicherkondensatoren ist im IBM Technical Disclosure Bulletin, Vol. 18, No. 3, August 1975, Seiten 786 und 787, und durch die DE—C 2 431 079 bekannt geworden. Hiernach ist jede Speicherzelle aus zwei Reihenschaltungen mit je einem Speicherkondensator und einem Schreib-/Lese-Feldeffekttransistor aufgebaut. Diese Reihenschaltungen sind zwischen den zwei Bitleitungen eines Bitleitungspaares und einem gemeinsamen, wechselstrommäßig auf Massepotential liegenden Verbindungspunkt angeordnet. Eine gemeinsame Wortleitung verbindet die Steuerelektroden der beiden Transistoren. Beim Auslesen der Information einer adressierten Speicherzelle wird das Differenzsignal auf beiden Bitleitungen zur Verstärkung einer Verriegelungsschaltung zugeführt.

Durch diese Schaltungsanordnung wird eine hohe Schreib- und Lesegeschwindigkeit bei jeweils relativ einfacher Steuersignalfolge erzielt.

Zur weiteren Verbesserung der Geschwindigkeit und Vereinfachung der Zeitsteuerung ist in der DE—B 2 712 735 eine frühzeitige Selektion der Bitleitungsschalter, die zur Verbindung von Speicherzellenbereich und Datenein-/ausgabeleitungen erforderlich sind, mit einem niedrigen Steuerimpuls gezeigt, so daß in Abhängigkeit von dem sich entwickelnden, von einer Speicherzelle auf das zugehörige Bitleitungspaar gebrachten und vorzugsweise vorverstärken Differenzsignal nur für einen der beiden Bitleitungsschalter die Einschaltschwelle überschritten wird, während der Bitleitungsschalter in der anderen Bitleitung gesperrt bleibt und ein Absinken des Potentials dieser Bitleitung und des damit verbundenen Zellknotens verhindert.

Eine weitere Herabsetzung der Zugriffszeit durch Verkürzung der Zeitspannen zur Abfühlung der gespeicherten Größen ist nicht ohne weiteres möglich, da nämlich sonst einerseits die Information nicht mehr zuverlässig zu erkennen wäre und andererseits die Geschwindigkeit bei zu starker Verringerung des abgefühlten Signals sowieso niedriger würde.

Derartige Schaltungsanordnungen mit dynamischen Ein- oder Zwei-Transistor-Speicherzellen haben noch den Nachteil, daß die Abfühlverriegelungsschaltung für hochintegrierte TTL-kompatible Speicherchips alleine nicht ausreicht, um die äußerst kleine Differenzspannung schnell in TTL-Signale umzusetzen, insbesondere, wenn der Datenpfad zu bzw. von den Speicherzellen eine hohe Kapazität aufweist. Vor allem die parasitäre Kapazität der internen Datensammelleitung, mit der die vielen Bitleitungen verbunden sind, verringert merklich die Schreib- und Lesegeschwindigkeit und beeinträchtigt außerdem eine zuverlässige Erkennung und Übertragung der Information.

Durch die an sich bekannte Verwendung einer zweiten Verriegelungsschaltung für die Datensammelleitung ist zwar eine Erhöhung der Lesegeschwindigkeit möglich. Die gleichartige Verwendung einer derartigen zweiten Verriegelungsschaltung sowohl zum Lesen als auch zum Schreiben wurde bisher nicht in Betrachtung gezogen.

Der Erfindung liegt deshalb die Aufgabe zugrunde, einen integrierten Halbleiterspeicher der eingangs genannten Art zu schaffen, der trotz Erhöhung der Integrationsdichte sowie der Schreib- und Lesegeschwindigkeit ein zuverlässiges Schreiben oder Abfühlen ohne komplizierte Steuersignalfolgen ermöglicht.

Die erfindungsgemäße Lösung ist im Kennzeichen des Patentanspruchs 1 angegeben.

Weitere Ausgestaltungen der Erfindung sind in den Ansprüchen 2 bis 4 angegeben.

Durch die Einfügung einer weiteren Verriegelungsschaltung in die kapazitätsreiche Datenstrecke zwischen den Bitschaltern und den TTLkompatiblen Datenein-/ausgang wird eine sehr schnelle Entladung der einen Datensammelleitung erzielt, ohne daß das hohe Ruhepotential der anderen Datensammelleitung merklich verringert würde. Denn diese Verriegelungsschaltung wirkt beim Schreiben und beim Lesen als zusätzliche Verstärkerstufe. Dadurch ergibt sich eine relativ hohe Datenübertragungsgeschwindigkeit bei einem eingangs- bzw. ausgangsseitigen TTL-Datensignal. Trotzdem wird die Übertragung auf dem Datenweg zwischen dem Ein-/Ausgang und der Speichermatrix mit einer minimalen Anzahl von Impulsen gesteuert, die größtenteils für die Schreib- und Leseoperation identisch sind, insbesondere die Aktivierimpulse für die Kippstufen der beiden identischen Verriegelungsschaltungen.

Erreicht wird diese kurze Schreibzeit und die hohe Zuverlässigkeit also durch das in einfacher Weise zeitlich gesteuerte Zusammenwirken der zusätzlichen Verriegelungsschaltung mit dem Schreibtreiber einerseits sowie der über Bitschalter frühzeitig selektierten Bitleitung und der adressierten Speicherzelle einschließlich der zugehörigen Abfühlverriegelungsschaltung andererseits.

Die Erfindung wird nun anhand von in den Zeichnungen dargestellten Ausführungsbeispielen näher beschrieben.

Es zeigen:

Fig. 1 ein Blockschaltbild eines integrierten Halbleiterspeichers mit einem gemeinsamen Dateneingang und -ausgang;

Fig. 2 eine Schaltungsanordnung zur Erhöhung der Schreib-/Lesegeschwindigkeit eines Speichers mit dynamischen Speicherzellen und TTL-kompatiblem Datenein-/ausgang bei Verarbeitung sehr kleiner Signale;

Fign. 3 und 4 Impulsdiagramme für die Schaltungsanordnung nach Fig. 2.

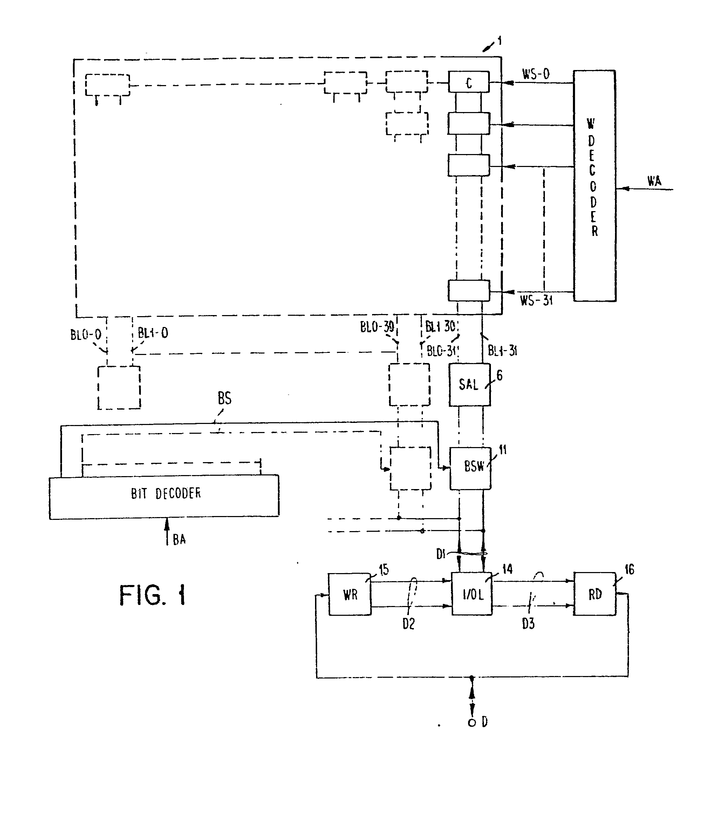

Anhand des Blockschaltbildes nach Fig. 1 wird der prinzipielle Aufbau der erfindungsgemäßen Schaltungsanordnung beschrieben. Der hochintegrierte Matrixspeicher 1 enthält dynamische Speicherzellen C mit je zwei Kondensatoren und zwei Feldeffekttransistoren und ist über Wortdecoder und Bitdecoder adressierbar. Die Speicherzellen C liegen dabei jeweils im Kreuzungspunkt einer Wortleitung WS und eines Bitleitungspaares BL0, BL1. Bei Anliegen einer bestimmten Wortadresse WA am Eingang des Wortdecoders und einer Bitadresse BA am Eingang des Bitdecoders wird innerhalb der Speichermatrix 1 diejenige Zelle C ausgewählt, die sich im Kreuzungspunkt der selektierten Wortleitung und des selektierten Bitleitungspaares befindet. Jedem Bitleitungspaar BL0, BL1 ist unmittelbar eine Abfühl-Verriegelungsschaltung 6 zugeordnet, die beim Lesen die selektierte Speicherzelle C abfühlt und deren gespeicherte Information übernimmt. Die Selektion eines Bitleitungspaares erfolgt über den Bitdecoder und die Bitschalter-Auswahlleitung BS. Durch einen Bitschalter 11 werden das Bitleitungspaar BL0, BL1 und die hier als bidirektionale Doppelleitung D1 ausgeführte Datenleitung miteinander verbunden. An diese Leitung D1 ist eine weitere Verriegelungsschaltung 14 angeschlossen, die beim Lesen von der als Vorverstärker wirkenden Abfühlverriegelungsschaltung 6 die Information übernimmt und die zugehörige Differenzspannung weiter verstärkt. Diese Verriegelungsschaltung 14 ist über je eine als unidirektionale Doppelleitung D2 bzw. D3 ausgeführte Datenleitung mit einem Schreibtreiber 15 einerseits und mit einem Lesetreiber 16 andererseits verbunden. Der Ausgang des Lesetreibers 16 und der Eingang des Schreibtreibers 15 sind beide mit der externen Datenleitung D verbunden. Die Datenleitung D ist als bidirektionale Einzelleitung ausgeführt, so daß hierüber sowohl die Daten übertragen werden, die in den Speicher einzuschreiben sind als auch die, die aus dem Speicher gelesen werden. Ein dem Wortdecoder, dem Bitcoder, der Verriegelungschaltung 14, dem Schreibtreiber 15 und dem Lesetreiber 16 zugeführtes — nicht dargestelltes — Signal dient zur Vorbereitung dieser Schaltungen und ist vergleichbar mit dem von anderen Speichern her bekannten Signal CHIP EIN (ENABLE).

Die internen Datenleitungen sind also von der externen Datenleitung weitgehend entkoppelt, so daß Störungen von außen nicht in den Speicher gelangen können und die Arbeitsgeschwindigkeit des Speichers im wesentlichen von den internen parasitären Leitungskapazitäten bestimmt wird. Durch Zufügung einer weiteren Verstärkerstufe in Gestalt der Verriegelungsschaltung 14 wird der schädliche Einfluß der aufgrund der Speicherorganisation hohen Kapazität der internen Datensammelleitung — in der Darstellung D1 bis D3 — minimiert, ohne daß die Zeitsteuerung der Datenübertragungsstrecke kompliziert wird.

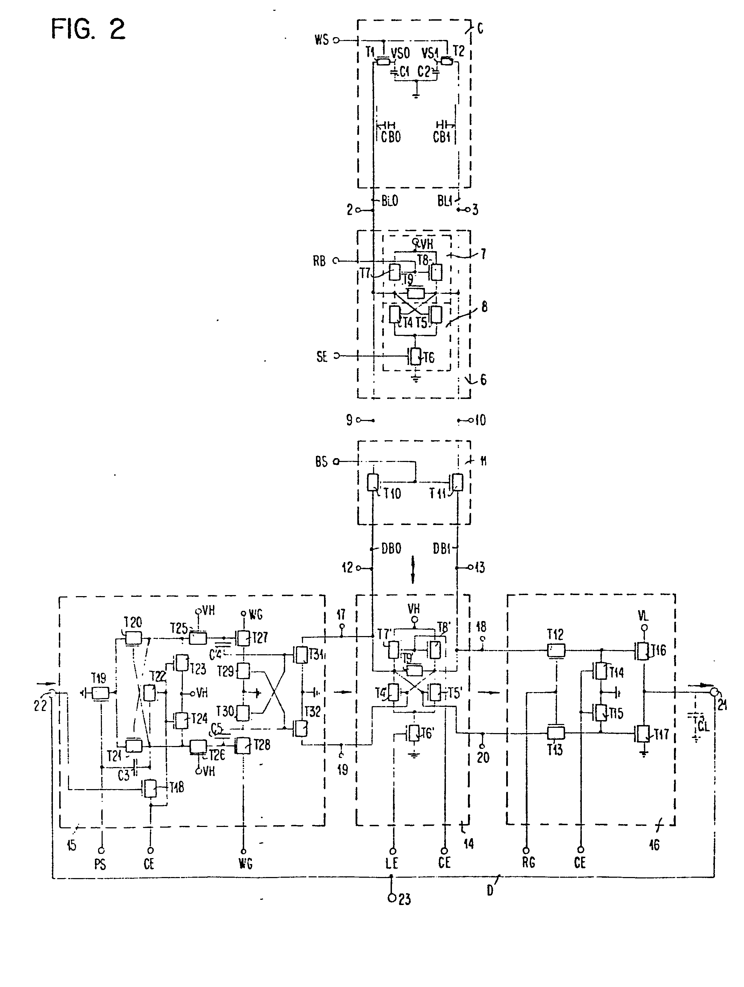

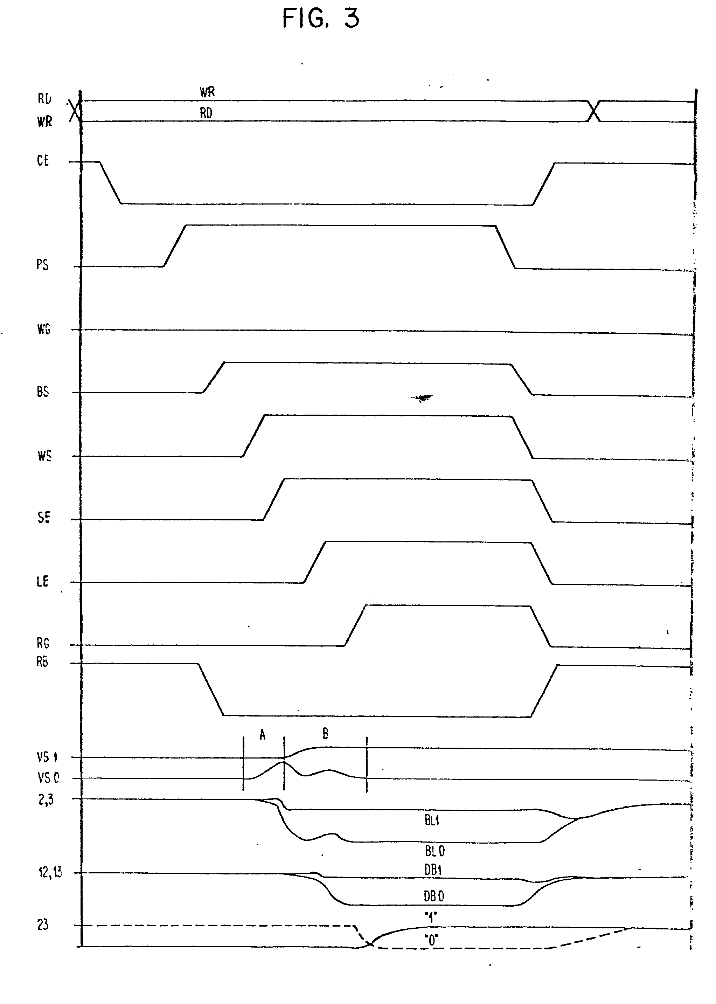

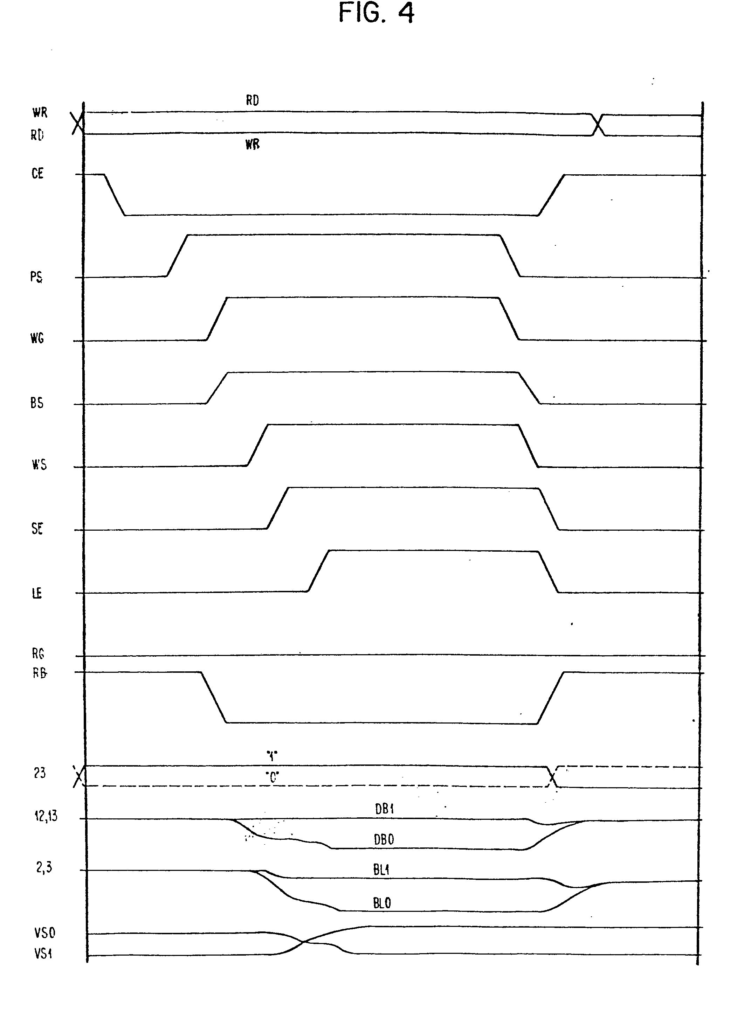

Die Lese- und Schreiboperationen werden detailliert anhand der Fig. 2 und deren Impulsdiagramme nach den Figuren 3 und 4 erklärt, so daß hier diesbezüglich keine weiteren Ausführungen folgen.

Es soll hier erwähnt werden, daß die gezeigte Schaltungsanordnung zwar in Verbindung mit einer dynamischen Speicherzelle, bestehend aus zwei Feldeffekttransistoren und zwei Kondensatoren, beschrieben wird, daß die Erfindung jedoch nicht auf diese spezielle Art von Speicherzellen beschränkt ist, sondern daß jede dynamische Speicherzelle, die über ein Bitleitungspaar und eine Wortleitung selektierbar ist, insbesondere auch eine dynamische Speicherzelle in bipolarer Technik, genauso betrieben werden kann.

Figur 2 zeigt die detaillierte Schaltung zum Steuern und Betreiben des Datenpfades eines Halbleitermatrixspeichers mit dynamischen Speicherzellen C aus je zwei Kondensatoren C1 und C2 sowie zwei Feldeffekttransistoren T1 und T2.

Eine derartige Zwei-Transistor-Speicherzelle C ist symmetrisch aufgebaut, indem von jeder der beiden Bitleitungen BL0 und BL1 eine selektierbare Verbindung über die Schreib-/Lese-Feldeffekttransistoren T1 bzw. T2 zu einem der beiden Speicherkondensatoren C1 bzw. C2 führt. Mit ihrer anderen Elektrode sind die Kondensatoren C1 und C2 auf ein festes Potential, wechselstrommäßig also auf Masse, gelegt. Die Wortleitung ist mit den beiden Steuerelektroden der Transistoren T1 und T2 verbunden. Durch ein entsprechendes Adressierungssignal WS auf dieser Wortleitung können die beiden Transistoren T1 und T2 der Speicherzelle ein-

**0 012 802**

geschaltet werden, und über die Bitleitungen BLO und BL1 kann dann die durch den jeweiligen Ladungszustand der Speicherkondensatoren C1 und C2 repräsentierte Information ausgelesen, regeneriert oder umgeschrieben werden. Symbolisch sind in dem Block, der eine Reihe solcher Speicherzellen C umfaßt, noch die parasitären Bitleitungskapazitäten CBO und CB1 eingezeichnet. Die Anschlußpunkte 2 und 3 stellen den Ein- bzw. Ausgang der Speicherzellen dar, je nachdem, ob eine Schreib- oder eine Leseoperation abläuft.

Mit den beiden Punkten 2 und 3 der Speicherzelle C ist eine Abfühl-Verriegelungsschaltung 6 verbunden, die ihrerseits aus einer Regenerierschaltung 7 und einer getakteten Verriegelungsschaltung 8 besteht. Das zwischen den Verbindungspunkten 2 und 3 beim Lesen auftretende sehr kleine Differenzsignal wird von der getakteten Verriegelungsschaltung 8, dem eigentlichen Leseverstärker, vorverstärkt. Diese getaktete Verriegelungsschaltung 8 ist aus den kreuzgekoppelten Transistoren T4 und T5 sowie dem in deren gemeinsame Source-Leitung eingefügten Transistor T6 aufgebaut. Über den Steuereingang SE wird der Transistor T6 durch einen Taktimpuls SE eingeschaltet, so daß die kreuzgekoppelten Feldeffekttransistoren T4 und T5 an die Betriebsspannung, hier Massepotential, gelegt werden. Bei diesem Leseverstärker handelt es sich demnach um eine bistabile Kippschaltung, die infolge der fehlenden Lastelemente und der (anfänglichen) Entkopplung von den ziemlich hohen Datenleitungskapazitäten extrem schnell schaltet. Der obere Schaltungsteil der Abfühlverriegelungsschaltung 6 stellt die Regenerierschaltung 7 dar und umfaßt die Transistoren T7 bis T9. Die Torelektroden dieser Transistoren sind miteinander und mit dem Steuereingang, an dem der Steuerimpuls RB anliegt, verbunden. Es ist festzuhalten, daß die Steuersignale RB und SE zu keinem Zeitpunkt gleichzeitig den oberen Spannungspegel aufweisen (vgl. Figur 3). Daraus ergibt sich, daß die Regeneriertransistoren T7 und T8 nicht als Lastelemente der kreuzgekoppelten Transistoren T4 und T5 wirken, so daß zusätzlich zur hohen Schaltgeschwindigkeit noch der Vorteil kommt, daß keine Dauerverlustleistung in der Verriegelungsschaltung 6 auftritt.

Die beiden Anschlußpunkte 9 und 10 der Verriegelungsschaltung 6 sind mit Bitschaltern 11 verbunden, die aus den Transistoren T10 und T11 bestehen. Die Bitschalter 11 stellen an dieser Stelle selektiv den Anschluß der Bitleitungen BLO und BL1 zu der als bidirektionale Doppelleitung DBO, SB1 ausgebildeten Datenleitung her. Dem gemeinsamen Steuereingang der Transistoren T10 und T11 wird ein Auswahlimpuls BS zugeführt, dessen Amplitude so groß eingestellt ist (VH — VT), daß in Abhängigkeit von dem sich entwickelnden, aus der Speicherzelle C auf das zugehörige Bitleitungspaar BLO, BL1 übertragenen und vorverstärkten Differenzsignal nur bei einem der beiden Transistoren T10 oder T11 die Einschaltschwelle weit überschritten wird, während der andere gerade gesperrt bleibt. Durch eine derartige Impulsamplitude an den Bitschaltern 11 wird eine frühzeitige Selektion und damit eine weitgehende Unabhängigkeit der Speicherzugriffszeit vom zeitlichen Auftreten des Auswahlimpulses BS ermöglicht, da die Bitleitung, die ihr hohes Ruhepotential (etwa Vh) behalten und den mit ihr verbundenen Speicherknoten regenerieren soll, von der entsprechenden Datenleitung völlig entkoppelt ist und somit von eren niedrigerem Potential (etwa VH — VT) nicht beeinflußt werden kann.

Der bidirektionalen Doppelleitung DBO, DB1 ist an den Anschlußpunkten 12 und 13 eine weitere getaktete Abfühl-Verriegelungsschaltung 14 zugeordnet. Diese besteht, wie die getaktete Abfühl-Verriegelungsschaltung 6, aus einem oberen und einem unteren Teil. Da der Aufbau der beiden Abfühl-Verriegelungsschaltungen 6 und 14 identisch ist, wird hier nicht weiter darauf eingegangen. Alle Transistoren der Verriegelungsschaltung 14 sind genauso bezeichnet wie die der oben beschriebenen. Die Bezugszeichen der Bauelemente sind lediglich mit einem Strichchen zur Unterscheidung versehen. Beim Lesen einer Information übernimmt wieder der untere Teil der getakteten Verriegelungsschaltung 14 die Verstärkung des zwischen den Anschlußpunkten 12 und 13 anliegenden Differenzsignals, und der obere Teil ist während der Regenerationsphase aktiv. Von der Verriegelungsschaltung 14 verzweigt sich das Datenleitungspaar DBO, DB1 einmal über den Schreibtreiber 15 (Anschlußtor 17, 19) und zum anderen über den Lesetreiber 16 (Anschlußtor 18, 20) jeweils unidirektional zur Datenleitung D.

Der Lesetreiber 16 besteht aus den Transistoren T12 bis T17 und ist an seinem Ausgang 21 über die Datenleitung D mit dem Eingang 22 des Schreibtreibers 15 verbunden. Die Datenleitung D besitzt ihrerseits einen Anschlußpunkt 23, auf dem während der Leseoperation Daten entnommen und während der Schreiboperation Daten eingegeben werden können.

Zur Erklärung der Funktionsweise des Lesetreibers 16 während einer Leseoperation wird nun zunächst angenommen, daß sich nach Aktivierung der Verriegelungsschaltung 14 mit Hilfe des Impulses LE am Ausgang (Anschlußpunkte 18 und 20) eine Differenzspannung ausgebildet hat, wobei der eine Knoten das Potential VH — VT und der andere Knoten das Potential 0 V angenommen hat. Das Signal CE ist zu diesem Zeitpunkt 0 Volt, so daß sich die Transistoren T14 und T15 im Auszustand befinden. Wenn nun das Signal RG von 0 Volt auf VH ansteigt, werden die Übertragungstransistoren T12 und T13 eingeschaltet und die eingangsseitige Information wird den Torelektroden der beiden Ausgangstransistoren T16 und T17 zugeführt. Beim Auslesen einer logischen Null entsprechend den Pegeln VH — VT bzw. 0 V an den Eingängen DB0 und DB1 des Lesetreibers 16 wird der Entladetransistor T17 leitend und der Aufladetransistor T16 nichtleitend. Nach Entladung der Lastkapazität CL ergibt sich am Datenausgang 21 ein Potential von 0 V, das der gespeicherten Null entspricht. Bei einer logischen Eins mit dem Potential VH — VT am Eingangsanschlußpunkt 18 und dem Potential 0 V am Anschlußpunkt 20 wird der Aufladetransistor T16 ein- und der Entladetransistor T17 ausgeschaltet, wodurch die Lastkapazität CL aufgeladen wird und am Anschlußpunkt 21 das eine gespeicherte Eins repräsentierende Potential VL auftritt. Am Ende der Selektionsphase geht das Signal RG vom oberen Pegel VH auf den unteren Pegel 0 V, so daß die Übertragungstransistoren T12 und T13 abgeschaltet werden. Damit sind auch die beiden Ausgangstransistoren T16 und T17 von den Anschlußpunkten 18 und 20 getrennt, d.h. der Ausgang des Lesetreibers 16 ist von der Verriegelungsstufe 14 isoliert. Anschließend geht das Signal CE hoch, wodurch die Transistoren T14 und T15 einund die Transistoren T16 und T17 ausgeschaltet werden. Somit ist der Datenausgang 21 im Ruhezustand vom Lesetreiber 16 entkoppelt.

Das Impulsediagramm für die Leseoperation ist in Fig. 3 dargestellt. Die obere Zeile zeigt den Signalverlauf des Schreibund des Lesesignals WR und RD, die zweite Zeile das Chipauswahlsignal CE und die dritte den Signalverlauf PS am Ausgang eines nicht im Schaltbild dargestellten Phasensplittreibers. Darunter ist der Signalverlauf für das Schreibsignal WG dargestellt, das sich bei der Leseoperation immer auf Nullpegel befindet. Danach folgen die Signale für die Bitselektion BS und Wortselektion $\overline{WS}$, dann die Einschaltsignale SE für die Verriegelungsschaltung 6, LE für die Verriegelungsschaltung 14, RG für den Lesetreiber 16, das Signal RB für das Nachladen der Bitleitungen sowie die Potentialverläufe VS0 und VS1 an den in der Fig. 2 markierten Punkten der Speicherzelle, BL0 und BL1 auf dem Bitleitungspaar, DB0 und DB1 auf den Datenleitungen DB1 an den Anschlußpunkten 12 und 13 und schließlich der Spannungsverlauf am Datenausgang des Speichers, und zwar am Anschlußpunkt 23 für eine gelesene Eins bzw. Null. Der Abschnitt A im Spannungsverlauf von VS1 und VS0 zeigt den Bereich für das zerstörende Auslesen und der anschließende Abschnitt B den Zeitbereich für das Wiedereinschreiben.

Im Nachfolgenden soll nun anhand der Figuren 2 und 4 die Schreiboperation, d.h. das Einschreiben einer Eins oder einer Null, erklärt werden. Das einzuschreibende Signal liegt dabei am Anschlußpunkt 23 der Schaltung nach Fig. 2 und gelangt von da zum Dateneingang 22 des Schreibtreibers 15.

Der Schreibtreiber 15 besteht aus fünf Stufen: einer Regenerierstufe mit den Transistoren T22 bis T24, einer Eingangsstufe mit dem Transistor T18 und dem Kondensator C3, einer Verriegelungsstufe mit den Transistoren T19 bis T21, einer Bootstraptreiberstufe mit aus den Transistoren T25 bis T30 und den Kondensatoren C4 und C5 sowie einer Ausgangsstufe mit den Transistoren T31 und T32. Im übrigen entspricht der Schreibtreiber 15 hinsichtlich seines Aufbaus und seiner Wirkungsweise weitgehend der Schaltung in der DE—B 2 712 735, so daß hier auf detaillierte Ausführungen verzichtet werden kann. Dennoch soll aber nachfolgend kurz die Arbeitsweise dieses Treibers beschrieben werden, soweit es für das Verständnis der Schreiboperation erforderlich ist.

Im Ruhezustand, d.h. wenn sich das Chipauswahlsignal CE auf dem oberen Pegel und die anderen Steuersignale des Schreibtreibers 15 auf dem unteren Pegel befinden, sind die Ausgänge der Verriegelungsstufe, und zwar die Torelektroden der Transistoren T20 und T21, und folglich auch die Eingänge der Bootstrapstufe, und zwar die Steuerelektroden der Transistoren T27 und T28, durch die Regenerierstufe je auf das Potential VH — VT geladen. Damit sperrt der Eingangstransistor T18, so daß eine eventuell an seiner Torelektrode anstehende Information nicht beachtet wird. Die leitenden Transistoren T27 und T28 halten die Ausgangstransistoren T31 und T32 wegen WG = 0 V im Sperrzustand. Deshalb kann sich am Ausgangsklemmenpaar 17, 19 des Schreibtreibers 15 über die Regeneriertransistoren T7' und T8' der Verriegelungsschaltung 14 ebenfalls jeweils das Ruhepotential VH — VT einstellen, wobei der Ausgleichstransistor T9' eine eventuelle Spannungsdifferenz zwischen den beiden kreuzgekoppelten Torelektroden sicher verhindert.

Spätestens vor Erscheinen des Chipaktivierpulses CE muß die gültige Information am Dateneingang 23 bzw. 22 anliegen. Wenn nun der Chipeinschaltimpuls CE seinen unteren Pegel annimmt, wird der Eingangstransistor T18 aktiviert, d.h. es bildet sich eine hohe Drain-Source-Spannung aus. Je nachdem, ob eine logische Null oder Eins ansteht, bleibt der Transistor T18 gesperrt oder geht in den leitenden Zustand über. Im Falle einer Null wird das Torpotential vom Transistor T20 über den Koppelkondensator C3 bei ansteigender Flanke des Steuerimpulses PS leicht erhöht, während es bei einer Eins trotz derselben Einkopplung durch den eingeschalteten Transistor T18 um etwa den gleichen Betrag verringert wird. In beiden Fällen bleibt das Ruhepotential an der Steuerelektrode des Transistors T21 erhalten. Durch die so erzeugte Differenzspannung ist der Verriegelungsstufe eine der beiden möglichen Vorzugslagen eingeprägt. Sobald der Setzimpuls PS den oberen Pegel erreicht hat und der Entladetransistor T19 voll leitend ist, wird diese kleine Differenzspannung verstärkt und durch die kreuzgekoppelten Transistoren T20 und T21 verriegelt, d.h. der eine Ausgang der Verriegelungsstufe wird entladen, wohingegen der andere sein hohes Ausgangspotential (VH — VT) im wesentlichen beibehält. Diese Potentiale stellen sich auch an den entsprechenden Torelektroden der Treibertransistoren T27 und T28 ein. Wenn der Schreibbefehlsimpuls WG vom unteren auf den oberen Pegel ansteigt, wird die eingangsseitige Differenzspannung VH – VT durch die Bootstraptreiberstufe (T27, T28; C4, C5) ausgangsseitig auf den Wert VH erhöht und durch die kreuzgekoppelten Klemmtransistoren T29 und T30 verriegelt. Die Torelektroden der Ausgangstransistoren T31 und T32 werden also auf die Spannung VH bzw. 0 V gebracht. Daher ist der eine Transistor der Ausgangsstufe (T31, T32) mit der Gatespannung VH stark leitend, während der andere mit dem Gatepotential 0 V sperrt. Im Falle einer einzuschreibenden Null wird die Datenleitung DB1 über T32 nach Masse entladen, während die Datenleitung DB0 durch den ausgeschalteten Transistor T31 unbeeinflußt ist und ihr Ausgangspotential VH – VT behält; im Falle einer einzuschreibenden Eins ist es umgekehrt. Auf dem Datensammelleitungspaar bildet sich somit die Spannungsdifferenz VH – VT aus, die dann in die selektierte Speicherzelle übertragen wird. Am Ende der Selektion werden die Steuerimpulse PS und WG abgeschaltet. Dadurch geht der zuvor leitende Ausgangstransistor (T31 oder T32) in den Sperrzustand über. Mit ansteigender CE-Flanke wird die Schaltung wieder für den Ausgangszustand des nächsten Schreibzyklus vorbereitet.

Festzuhalten ist, daß der Schreibtreiber das eingangsseitig anliegende niedrige TTL-Signal in eine hohe Spannungsdifferenz VH – VT am kapazitiv stark belasteten Ausgang umsetzt. Dies erfolgt im wesentlichen in drei Schritten: Zunächst wird der Eingangspegel zur Erzeugung einer kleinen Differenzspannung an einer Verriegelungsstufe benutzt; diese Spannungsdifferenz wird dann durch Wirkung des Verriegelungsschaltkreises vorverstärkt und schließlich durch Einführung eines Steuerimpulses mit hoher Amplitude (VH) unter Ausnutzung der Bootstrap-Technik weiter verstärkt. Damit ist zur Ansteuerung der Ausgangsstufe (T31, T32) eine hohe Spannungsdifferenz — d.h. VH an der einen und 0 V an der anderen Torelektrode — verfügbar.

Das Schreibprinzip besteht nun darin, daß nur eine der Datenleitungen DB0 und DB1, die beide vorher auf gleiches und hohes Potential (VH – VT) aufgeladen worden sind, je nach Information am Dateneingang über den Ausgangstransistor T31 bzw. T32 entladen wird, während die komplementäre Datenleitung jeweils aufgeladen bleibt. Bei entsprechend großer Dimensionierung könnte die Entladung der ziemlich hohen Datenleitungskapazität durch den Schreibtreiber alleine bewerkstelligt werden. Um aber Layoutfläche zu sparen, werden die beiden Verriegelungsschaltungen 6 und 14, die zur Durchführung einer Leseoperation ohnehin erforderlich sind, zur Unterstützung beim Entladevorgang herangezogen. Sobald nämlich das Potential der einen Datenleitung genügend weit abgesunken ist, öffnet der entsprechende Bitschalter 11. Dadurch kann sich auch am Bitleitungspaar rechtzeitig ein Differenzsignal ausbilden, das von der in der Speicherzelle enthaltenen Information nicht umgeschrieben werden kann, da die Zelle zu diesem Zeitpunkt noch nicht voll selektiert ist. Dieses Differenzsignal nimmt infolge der immer noch anhaltenden Entladung über die Ausgangsstufe des Schreibtreibers noch leicht zu und wird bei Erscheinen des Setzpulses SE durch die Verriegelungsschaltung 6 merklich verstärkt, die nun auch die weitere Entladung der einen Datenleitung übernimmt. Mit Aktivierung des zusätzlichen Verriegelungsschaltung 14 zur LE-Zeit wird ein dritter Entladepfad für die hohe Datenleitungskapazität und — wegen des eingeschalteten Bitschalters 11 — auch für die entsprechende Bitleitungskapazität CB eröffnet, so daß nunmehr schnell die parasitären Leitungskapazitäten sowie der damit verbundene Speicherknoten entladen werden können, während die komplementären Leitungskapazitäten ihr Ausgangspotential in etwa behalten, dem sich der zugehörige Speicherknoten angleicht. In dem Zeitdiagramm nach Fig. 4 sind für eine einzuschreibende Eins die Potentialverläufe an den Klemmen 23; 12, 13 und 2, 3 sowie die Potentiale VS0 und VS1 der Speicherknoten dargestellt. Die übrigen Impulsverläufe in dem darüberliegenden Teil des Diagramms entsprechen denen gemäß Fig. 3 für die Leseoperation. Der einzige Unterschied besteht darin, daß das Lesesignal RG in Fig. 4 unten ist und das Schreibsignal WG oben.

Damit ist gezeigt, daß für das Lesen und Schreiben des dynamischen Speichers gemäß der Schaltung in Fig. 2 zum einen die gleichen Impulszüge verwendet werden können und zum anderen zwei bzw. drei Schaltungskomponenten zur Verfügung stehen, um die hohe parasitäre Kapazität auf den internen Datenleitungen DB0 bzw. DB1 zu entladen, so daß ein schnelleres Auslesen und Einschreiben als bisher erreicht wird.

**Patentansprüche**

1. Integrierter Halbleiterspeicher mit kapazitiv hochbelastetem, aber TTL-kompatiblem Datenein-/ausgang und dynamischen Speicherzellen (C), die an den Kreuzungspunkten von Wortleitungen (WS) und Bitleitungspaaren (BL0, BL1) matrixartig angeordnet sind, wobei jedem Bitleitungspaar eine Abfühlverriegelungsschaltung (6) zugeordnet ist, wobei die Bitschalter (11), die der genannten Abfühlverriegelungsschaltung (6) vor- bzw. nachgeschaltet sind, mit ihren kapazitätsreichen Ein- bzw. Ausgängen mit einer Datensammelleitung (DB0 und DB1) verbunden sind, an der eine weitere Verriegelungsschaltung (14) angeschlossen ist, welche außerdem mit dem gemeinsamen Datenein-/ausgang (23) über einen Lesetreiber (16) gekoppelt ist, dadurch gekennzeichnet, daß ein Schreibtreiber (15) direkt mit der zweiten Verriegelungsschaltung (14) verbunden ist, daß während einer Schreiboperation der Schreibtreiber (15) ein anliegendes TTL-Datensignal in eine hohe Potentialdifferenz zwischen den beiden kapazitätsreichen Leitungen der Datensammelleitung (DB0, DB1) umwandelt, die beide am Ende des vorhergehenden Zyklus auf gleich hohe Spannungspegel (VH − VT) aufgeladen werden, daß dann über den früh selektierten Bitschalter (11) die entsprechende Bitleitung (BL0 oder BL1) genügend weit und schnell entladen wird, bevor die gewünschte Speicherzelle (C) adressiert ist, daß das somit auf dem Bitleitungspaar (BL0, BL1) entstandene Signal durch die beigeordnete Abfühlverriegelungsschaltung (6) verstärkt und verriegelt wird, wobei die restliche Entladung der einen Bitleitung (BL0 oder BL1) durch die zweite Verriegelungsschaltung (14) beschleunigt wird, und daß abschließend die einzuschreibende Information von der ausgewählten Speicherzelle (C) übernommen wird.

2. Schaltungsanordnung nach Anspruch 1, dadurch gekennzeichnet, daß während einer Leseoperation die der selektierten Speicherzelle (C) unmittelbar zugeordnete Abfühlverriegelungsschaltung (6) die kleine Differenzspannung auf den beiden Bitleitungen (BL0, BL1) vorverstärkt, daß sofort nach genügender Entladung einer Bitleitung ein als Bitschalter (11) wirkender Transistor (T10 bzw. T11) eingeschaltet wird, während der andere (T11 bzw. T10) gesperrt bleibt, wodurch eine Spannungsdifferenz zwischen den beiden kapazitätsreichen Leitungen (12 und 13) der bidirektionalen Datensammelleitung (DB0, DB1) erzeugt wird, daß dann beim Aktivieren der zweiten, den Bitschaltern (11) nachgeschalteten Verriegelungsschaltung (14) das Potential einer der beiden Datensammelleitungen (DB0, DB1) und somit das Potential der entsprechenden Bitleitung (BL0 oder BL1) äußerst schnell abfällt, während die komplementäre Bitleitung ihr hohes Anfangspotential (VH − VT) behält, und daß schließlich der Lesetreiber (16) die hohe Potentialdifferenz in ein TTL-kompatibles Datensignal durch Herunter- oder Heraufziehen des Datenausgangs (21) konvertiert.

3. Schaltungsanordnung nach den Ansprüchen 1 und 2, dadurch gekennzeichnet, daß der Schreibtreiber (15) und der Lesetreiber (16) über eine Datenleitung (D) miteinander verbunden sind, die als Ein- und Ausgang (23) dient, wobei jedoch nur einer der genannten Treiber während eines Zyklus aktiv ist, und zwar entweder zum Einlesen eines Bits von der Datenleitung (D) oder zum Auslesen eines Datenbits.

4. Schaltungsanordnung, insbesondere mit Feldeffekttransistoren nach den Ansprüchen 1 bis 3, dadurch gekennzeichnet, daß beide Verriegelungsschaltungen (6 und 14) identisch sind und aus je einer bistabilen Kippschaltung mit zwei kreuzgekoppelten Transistoren (T4 und T5 bzw. T4′ und T5′), die über einen getakteten Transistor (T6, T6′) verriegelt werden, und einer Regenerierschaltung aufgebaut sind, welche aus zwei zwischen einer Spannungsquelle (VH) und der jeweiligen Bitleitung (BL0, BL1) bzw. Datensammelleitung (DB0, DB1) angeordneten Transistoren (T7 und T8 bzw. T7′ und T8′) und einem dritten Transistor (T9, T9′) besteht, der die genannten Bitleitung direkt miteinander verbindet.

**Revendications**

1. Mémoire à semi-conducteur intégrée comprenant des entrées/sorties de données à forte charge capacitive tout en étant compatible avec la logique TTL, et des cellules de mémoire agencées en matrice aux points d'intersection de lignes de mots et de paires de lignes de bits, une bascule à verrouillage de détection étant associée à chaque paire de lignes de bits, les commutateurs de bits (11), disposés en amont ou en aval de ladite bascule à verrouillage, étant connectés, par leurs entrées ou sorties à capacité élevée à un bus de données (DB0 et DB1), lui-même relié à une autre bascule à verrouillage (14) qui est en outre couplée à l'entrée/sortie de données commune (23) par un dispositif de commande de lecture (16) caractérisée en ce qu'un dispositif de commande d'écriture (15) est directement connecté à ladite autre bascule à verrouillage (14) et en ce que, durant une opération d'écriture le dispositif de commande d'écriture convertit un signal de données TTL en une différence de potentielle élevée entre les deux lignes à forte charge capacitive du bus de données (DB0 et DB1) lignes qui, à la fin du cycle précédent, sont chargées à des niveaux de tension égaux (VH − VT), en ce que, ensuite, par les commutateurs de bits antérieurement sélectionnées (11), la ligne de bits correspondante (BL0 ou BL1) est suffisamment et rapidement déchargée avant que n'ait été adressée la cellule d'emmagasinage respective (C), en ce que le signal ainsi formé sur la paire de lignes de bits (BL0, BL1) est amplifié et verrouillé par le circuit de bascule à verrouillage de détection associé (6), la décharge restante de l'une des lignes de bits (BL0 ou BL1) étant accélérée par la seconde bascule à verrouillage (14), et en ce que, finalement, l'information à écrire est reçue par la cellule d'emmagasinage sélectionnée (C).

2. Circuit selon la revendication 1, caractérisé en ce que, durant une opération de lecture, la bascule à verrouillage de détection (6) directement associée à la cellule de mémoire sélectionnée (C), préamplifie la faible tension différentielle sur les deux lignes de bits (BL0, BL1), en ce que, immédiatement après une décharge suffisante d'une ligne de bits, un transistor (T10 ou T11) jouant le rôle de commutateur de bits (11), est rendu conducteur, tandis que l'autre transistor (T11 ou T10) reste bloqué, de sorte qu'une différence de potentiel soit générée entre les deux lignes à forte charge capacitive (12 et 13) du bus de données bidirectionnel (DBO, DB1), en ce que, lors de l'activation de la seconde bascule à verrouillage (14) montée en série avec les commutateurs de bits (11), le potentiel de l'une des deux lignes de données (DBO, DB1) et, par voie de conséquence, le potentiel de la ligne de bits correspondante (BLO ou BL1), chute très rapidement, tandis que la ligne de bits complémentaire maintient son potentiel de départ élevé (VH -- VT), et en ce que, finalement, le dispositif fr vommznfr de lecture (16) convertit la différence de potentiel élevée en un signal de données compatible avec la logique TTL en relevant ou en abaissant la sortie de données (21).

3. Circuit selon l'une des revendications 1 et 2, caractérisé en ce que le dispositif de commande d'écriture (15) et le dispositif de commande de lecture (16) sont interconnectés par une ligne de données (D) qui sert d'entrée et de sortie (23), mais un seul desdits dispositifs étant actif durant un cycle, soit pour enregistrer un bit à partir de la ligne de données (D), soit pour extraire un bit de données.

4. Circuit selon l'une quelconque des revendications 1 à 3 plus particulièrement du genre mémoire à transistors à effet de champ, caractérisée en ce que les deux bascules à verrouillage (6 ou 14) sont identiques et comprennent respectivement un circuit basculeur bistable comportant deux transistors couplés en croix (T4 et T5), ou (T4' et T5') verrouillés par un transistor de synchronisation (T6, T6') et un circuit de régénération qui comprend deux transistors (respectivement T7 et T8, ou T7' et T8') montés respectivement entre une source de tension (VH) et la ligne de bits respective (BLO, BL1) ou le bus de données (DBO, DB1), et un troisième transistor (T9, T9') interconnectant directement lesdits lignes de bits.

**Claims**

1. Integrated semiconductor memory with capacitively highly loaded, but TTL-compatible input/output and dynamic memory cells arranged in a matrix at the points of intersection of word lines and bit line pairs, each bit line pair having an associated sense latch, the bit switches (11) which are arranged before or behind, respectively the above sense latch being connected with their highly capacitive inputs or outputs, respectively with a data bus (DBO and DB1) to another latch (14) which is furthermore coupled to the common data input/output (23) via a read driver (16), characterized in that a write driver (15) converts an applied TTL data signal into a high potential difference between the two capacitively highly loaded lines of the data bus (DBO, DB1) which at the end of the preceding cycle are charged to equal voltage levels (VH — VT), that subsequently, via the previously selected bit strips (11) the corresponding bit line (BLO or BL1) is discharged sufficiently and quickly before the respective storage cell (C) has been addressed, that the signal thus formed on the bit line pair (BLO, BL1) is amplified and latched by the associated sense latch circuit (6), with the remaining discharge of the one bit line (BLO or BL1) being accelerated by the second latch (14), and that finally the information to be written in is received by the selected storage cell (C).

2. Circuit arrangement as claimed in claim 1, characterized in that during a read operation the sense latch (6) directly associated with the selective memory cell (C) preamplifies the small differential voltage on both bit lines (BLO, BL1), that immediately after a sufficient discharge of a bit line a transistor (T10 or T11) acting as a bit switch (11) is switched on whereas the other one (T11 or T10) remains non-conductive, so that a voltage difference is generated between the two highly capacitive lines (12 and 13) of the bidirectional data bus (DBO, DB1), that upon the activation of the second latch (14) arranged in series to bit switches (11) the potential of one of the two data lines (DBO, DB1), and thus the potential of the corresponding bit line (BLO or BL1) drops very quickly, whereas the complementary bit line maintains its high starting potential (VH — VT), and that finally the read driver (16) converts the high potential difference into a TTL compatible data signal by pulling up or down that data output (21).

3. Circuit arrangement as claimed in any one of claims 1 and 2, characterized in that the write driver (15) and the read driver (16) are interconnected via a data line (D) which serves as an input and output (23), but with only one of the above mentioned drivers being active during a cycle, either for reading in a bit from the data line (D), or for reading out a data bit.

4. Circuit arrangement, in particular with field effect transistors as claimed in any one of claims 1 to 3, characterized in that both latches (6 and 14) are identical and are composed of one respective bistable flip-flop with two crosscoupled transistors (T4 and T5, or T4' and T5', respectively) latched via a clocked transistor (T6, T6'), and of a regenerating circuit which consists of two transistors (T7 and T8, or T7' and T8', respectively) arranged between a voltage source (VH) and the respective bit line (BLO, BL1), or data bus (DBO, DB1), respectively, and of a third transistor (T9, T9') directly interconnecting the above mentioned bit lines.

FIG. 1

0 012 802

# FIG. 2

## FIG. 3

3

0 012 802

FIG. 4

4